# EUROPÄISCHE PATENTSCHRIFT

(11) **EP 1 069 371 B1**
(45) Veröffentlichungstag und Bekanntmachung des Hinweises auf die Patenterteilung: **29.08.2007**
(21) Anmeldenummer: 00113959.1
(22) Anmeldetag: 01.07.2000
(51) Int. Cl.: H01L 25/075

(54) **Leuchtdiodenanordnung**
Light emitting diode device
Dispositif à diodes électroluminescentes

(30) Priorität: 15.07.1999 DE 19933060
(43) Veröffentlichungstag der Anmeldung: 17.01.2001
(73) Patentinhaber: Hella KGaA Hueck & Co., 59552 Lippstadt (DE)
(72) Erfinder: Reinbach, Martin, Howick, Auckland (NZ)

(56) Entgegenhaltungen:
- EP-A- 0 253 244
- US-A- 4 654 629
- US-A- 5 101 326
- US-A- 5 567 036
- PATENT ABSTRACTS OF JAPAN Bd. 017, Nr. 542 (E-1441), 29. September 1993 (1993-09-29) -& JP 05 152610 A (IWASAKI ELECTRIC CO LTD), 18. Juni 1993 (1993-06-18)

## Beschreibung

Die Erfindung betrifft eine Leuchtdiodenanordnung nach dem Oberbegriff des Patentanspruchs 1.

Die Erfindung betrifft weiterhin ein Verfahren zur schrägen Anordnung von einer Mehrzahl von Leuchtdioden auf einer Trägerplatte.

Insbesondere bei Signalleuchten für Kraftfahrzeuge besteht das Problem, daß häufig eine Abstrahlrichtung gewünscht ist, die nicht senkrecht zu einer Grundebene orientiert ist, sondern die gegenüber der Grundebene schräg orientiert ist.

Aus der DE 297 20 060 U1 ist eine Kraftfahrzeugleuchte bekannt, bei der eine Mehrzahl von Leuchtdioden mit ihrer Abstrahlrichtung gegenüber einer Grundebene schräg angeordnet sind. Zu diesem Zweck sind die Leuchtdioden auf Trägerplatten angeordnet, wobei ihre Abstrahlrichtung senkrecht zur Ebene der Trägerplatte angeordnet ist. Die Leuchtdioden weisen Grundkörper auf, die mit ihren Kontaktbeinchen in Führungsbohrungen der Trägerplatte befestigt sind.

Nachteilig bei der bekannten Signalleuchte ist, daß zur Neigung der Abstrahlrichtung gegenüber der Grundebene die Trägerplatten gegenüber der Grundebene geneigt bzw. schräg angeordnet werden müssen. Dies führt zu einer relativ komplizierten und aufwendigen Halterung der Trägerplatten. Auch muß eine Mehrzahl von Trägerplatten verwendet werden.

Weiterhin ist aus der DE 196 46 042 A1 eine Beleuchtungseinrichtung für Fahrzeuge bekannt, bei der die Abstrahlrichtung von Leuchtdioden, die auf einer räumlich gebogenen Trägerplatte angeordnet sind, durch spezielle vorgelagerte Umlenkelemente umgelenkt wird.

Nachteilig dabei ist, daß die Anordnung von Umlenkelementen ebenfalls relativ aufwendig und teuer ist.

Aus der JP 05152610 A ist eine Leuchtdiodenanordnung mit Leuchtdioden bekannt, deren Grundkörper jeweils geneigt zu einer Trägerplatte angeordnet sind. Die Leuchtdioden weisen jeweils Kontaktbeinchen auf, die in Führungsbohrungen der Trägerplatte eingreifen. Ein Hineinragen des Grundkörpers der Leuchtdiode in die Ebene der Trägerplatte ist nicht vorgesehen.

Aufgabe der vorliegenden Erfindung ist es daher, die bekannten Leuchtdiodenanordnungen so zu verbessern, daß die gewünschte schräge Orientierung der Abstrahlrichtung einfach und kostengünstig unter Verringerung der Bautiefe erreicht wird.

Diese Aufgabe wird erfindungsgemäß durch die Merkmale des Patenanspruchs 1 gelöst.

Dadurch, daß die Trägerplatte parallel zu der Grundebene angeordnet werden kann und lediglich die Leuchtdioden mit ihrem Grundkörper schräg auf der Trägerplatte angeordnet sind, läßt sich die Trägerplatte einfacher und kostengünstiger in einem sie umgebenden Gehäuse anordnen. Auch ist es möglich, nur mit einer Trägerplatte oder zumindest mit weniger Trägerplatten als bisher auszukommen. Die benötigte Einbautiefe wird bei dieser Lösung zudem erheblich verringert. Nach der Erfindung weist der Grundkörper an seinem der Trägerplatte in einem Abstand benachbarten ersten Ende ein erstes Paar von Kontaktbeinchen auf, deren freie Enden in Kontaktbohrungen der Trägerplatte befestigt sind, wobei der Grundkörper an seinem dem ersten Ende gegenüberliegenden zweiten Ende ein zweites Paar von Kontaktbeinchen aufweist, das den Grundkörper gegenüber der Trägerplatte mechanisch hält. Dabei weist die Trägerplatte einen Durchbruch auf, in den der Grundkörper mit seinem zweiten Ende so weit hineinragt, daß seine der Trägerplatte zugewandte Unterseite vorzugsweise gegen eine den Kontaktbohrungen zugewandte hintere Innenkante des Durchbruchs anschlägt.

Gemäß einer bevorzugten Ausführungsform der Erfindung liegt das zweite Paar von Kontaktbeinchen mit seinen freien Enden an einer Unterseite der Trägerplatte an. Dadurch, daß der Grundkörper mit seinem zweiten Ende in einen Durchbruch der Trägerplatte hineinragt, verringert sich die Bautiefe weiter. Durch die Abstützung des Grundkörpers auf der Innenkante des Durchbruchs und durch das Anliegen der freien Enden des zweiten Paares von Kontaktbeinchen an der Unterseite der Trägerplatte wird zudem eine relativ gute Stabilität erreicht, die ein unerwünschtes Vibrieren bzw. Erschüttern der Leuchtdioden verhindert.

Nach einer weiteren bevorzugten Ausführungsform der Erfindung wird der Neigungswinkel der Leuchtdiode durch die Breite des Durchbruchs bzw. durch die Anordnung der hinteren Innenkante bestimmt. Dadurch können auf einfache Weise unterschiedliche Abstrahlrichtungen erzielt werden.

Gemäß einer weiteren bevorzugten Ausführungsform der Erfindung sind die Leuchtdioden in unterschiedlichen Abstrahlrichtungen ausgerichtet. Es ist grundsätzlich möglich, in herkömmlicher Weise senkrecht auf der Trägerplatte angeordnete Leuchtdioden mit schräg angeordneten Leuchtdioden zu kombinieren.

Nach einer weiteren bevorzugten Ausführungsform der Erfindung weist die Trägerplatte auf ihrer den Leuchtdioden abgewandten Unterseite ein Wärmeableitelement auf.

Durch die Anordnung eines Wärmeableitelements wird die Leuchtdiodenanordnung einerseits vor Überhitzung geschützt und anderseits wird die mechanische Stabilität erhöht. Weitere Aufgabe der Erfindung ist es, die bekannten Verfahren zur schrägen Anordnung der Leuchtdioden zu verbessern.

Diese Aufgabe wird erfindungsgemäß dadurch gelöst, daß die Leuchtdioden in einem ersten Arbeitsgang mit ihrem an einem ersten Ende eines Grundkörpers angeordneten ersten Paar von Kontaktbeinchen in Führungsbohrungen der Trägerplatte eingesetzt werden, wobei die freien Enden eines an einem dem ersten Ende abgewandten zweiten Ende angeordneten zweiten Kontaktpaares in einen benachbarten Durchbruch hineinragen, daß die Leuchtdioden in einem zweiten Arbeitsgang mit ihrem ersten Paar von Kontaktbeinchen mit der Trägerplatte verlötet werden, daß die Leuchtdioden in einem dritten Arbeitsgang so abgebogen werden, daß die Grundkörper mit ihren zweiten Enden in die Durchbrüche hineinragen und mit ihren der Trägerplatte zugewandten Unterseiten an eine Innenkante des Durchbruchs anschlagen, und daß in einem vierten Arbeitsgang die freien Enden des zweiten Paares von Kontaktbeinchen gegen die Unterseite der Trägerplatte gebogen werden.

Dadurch, daß die Leuchtdioden schräg auf der Trägerplatte montiert werden, kann auf eine schräge Anordnung der Trägerplatte verzichtet werden. Durch die erfindungsgemäßen Arbeitsgänge ist es zudem möglich, diese zu automatisieren. Nach dem erfindungsgemäßen Verfahren lassen sich die Leuchtdioden relativ einfach und kostengünstig montieren. Zudem wird auf einfache Weise die benötigte Stabilität erreicht.

Die erfindungsgemäße Leuchtdiodenanordnung kann bei Heck-, Blink-, Seitenmarkierungs- und Innenleuchten für Kraftfahrzeuge verwendet werden.

Weitere Einzelheiten der Erfindung ergeben sich aus der nachfolgenden ausführlichen Beschreibung und den beigefügten Zeichnungen, in denen bevorzugte Ausführungsformen der Erfindung beispielsweise veranschaulicht sind.

In den Zeichnungen zeigen:

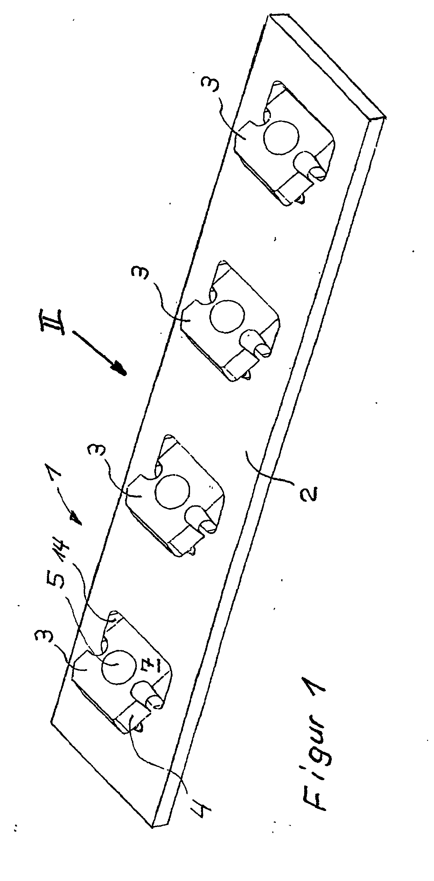

- Figur 1:: Eine räumliche Darstellung einer Leuchtdiodenanordnung in vergrößerter Darstellung,

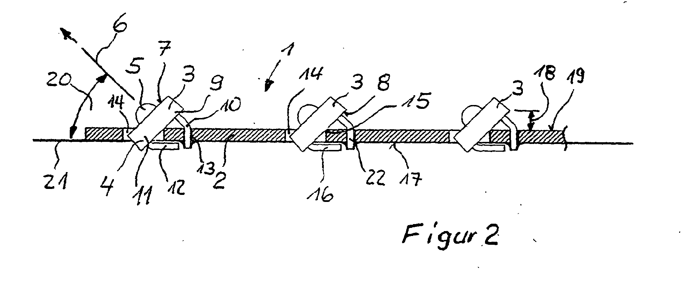

- Figur 2:: eine Seitenansicht der Leuchtdiodenanordnung von Figur 1 aus Richtung II im Schnitt,

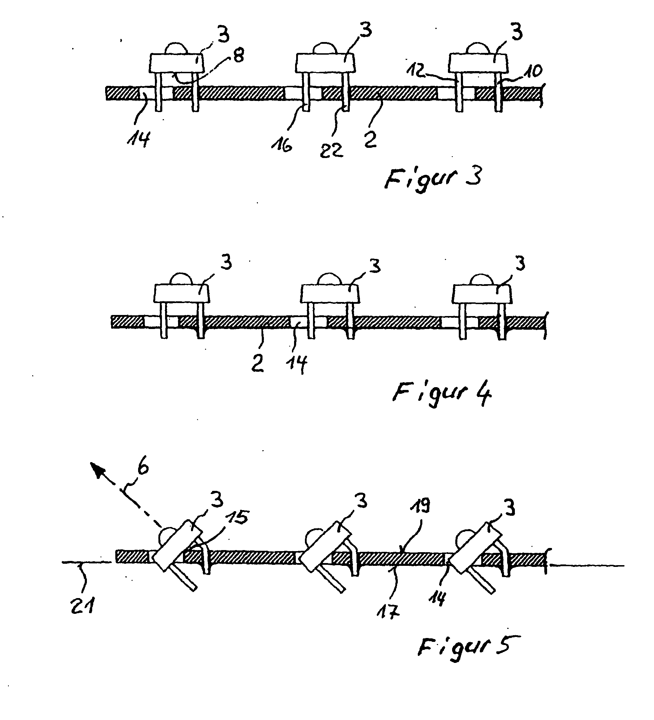

- Figur 3:: eine Seitenansicht der Leuchtdiodenanordnung von Figur 1 mit auf die Trägerplatte aufgesteckten Leuchtdioden,
- Figur 4:: die Leuchtdiodenanordnung von Figur 3 mit gelöteten ersten Paaren von Kontaktbeinchen und
- Figur 5:: die Leuchtdiodenanordnung von Figur 4 mit abgebogenen Hauptkörpern

Eine Leuchtdiodenanordnung 1 besteht im wesentlichen aus einer Trägerplatte 2 und einer Mehrzahl von Leuchtdioden 3 bzw. LEDs. Als Leuchtdioden 3 werden beispielsweise sogenannte Piranha-LEDs verwendet. Die Leuchtdioden 3 weisen einen Grundkörper 4 auf, über dessen Lichtaustrittsfläche 5 Licht abgestrahlt wird. Die Abstrahlrichtung 6 ist dabei senkrecht zur Grundkörperoberfläche 7 angeordnet. An seiner der Grundkörperoberfläche 7 abgewandten Unterseite 8 weist der Grundkörper an seinem ersten Ende 9 ein erste Paar von Kontaktbeinchen 10 auf. An seinem dem ersten Ende 9 gegenüberliegenden zweiten Ende 11 weist der Grundkörper 7 an seiner Unterseite 8 ein zweites Paar von Kontaktbeinchen 12 auf.

Die Trägerplatte 2 ist in bzw. parallel zu eine Grundebene 21 angeordnet. Die Trägerplatte 2 weist nicht dargestellte Leiterbahnen und gegebenenfalls ebenfalls nicht dargestellte elektronische Bauelemente zur Ansteuerung der Leuchtdioden 3 auf. Die Trägerplatte 2 weist für jede Leuchtdiode 3 zwei Führungsbohrungen 13 auf, in denen jeweils das erste Paar von Kontaktbeinchen 10 angeordnet ist. In einem Abstand zu den Führungsbohrungen 13 ist auf der Trägerplatte 2 jeweils ein Durchbruch 14 angeordnet, in den der benachbarte Grundkörper 4 mit seinen zweiten Ende 11 eintaucht. Der Durchbruch 14 weist dabei eine den Führungsbohrungen 13 zugewandte hintere Innenkante 15 auf, gegen die der Grundkörper 4 mit seiner Unterseite 8 anschlägt.

Das zweite Paar von Kontaktbeinchen 12 liegt mit seinen freien Enden 16 an einer Unterseite 17 der Trägerplatte 2 an.

Es ist grundsätzlich auch möglich, zwei oder mehrere parallel nebeneinander angeordnete Leuchtdioden 3 in einen gemeinsamen Durchbruch 14 eintauchen zu lassen.

Die Breite des Durchbruches 14 bzw. die Anordnung der hinteren Innenkante 15 bestimmt zusammen mit dem Abstand 18 von der Trägeroberfläche 19 den von Abstrahlrichtung 6 und Trägeroberfläche 19 gebildeten Neigungswinkel 20.

An der Unterseite 17 der Trägerplatte 2 kann ein nicht dargestelltes Wärmeableitelement angeordnet sein, über das Wärme von den LEDs 3 abgeleitet werden kann. Während das erste Paar von Kontaktbeinchen 10 zur mechanischen Halterung und zur elektrischen Kontaktierung genutzt wird, wird das zweite Paar von Kontaktbeinchen 12 lediglich zur mechanischen Halterung genutzt.

Zur Montage der Leuchtdiodenanordnung 1 werden in einem ersten Arbeitsgang die LEDs 3 mit ihrem jeweiligen ersten Paar von Kontaktbeinchen 10 bzw. deren freien Enden 22 in die Führungsbohrungen 13 der Trägerplatte 2 eingesetzt. Das zweite Paar von Kontaktbeinchen 12 ragt dabei mit seinen freien Enden 16 in den benachbarten Durchbruch 14.

In einem zweiten Arbeitsgang wird das erste Paar von Kontaktbeinchen 12 mit der Trägerplatte 2 bzw. deren Führungsbohrungen 13 verlötet.

In einem dritten Arbeitsgang werden die Grundkörper 4 so abgebogen, daß ihr zweites Ende in den benachbarten Durchbruch 14 hineinragt und sie mit ihrer der Trägerplatte 2 zugewandten Unterseite 8 an die hintere Innenkante 15 des Durchbruchs 14 anschlagen.

In einem vierten Arbeitsgang werden die freien Enden 16 des zweiten Paares von Kontaktbeinchen 12 gegen die Unterseite 17 der Trägerplatte 2 gebogen.

## Patentansprüche

1. Leuchtdiodenanordnung, insbesondere für eine Fahrzeugsignalleuchte, mit einer gegenüber einer Grundebene (21) schräg orientierten Abstrahlrichtung (6), bestehend aus einer Trägerplatte (2) und einer Mehrzahl von auf der Trägerplatte angeordneten Leuchtdioden (3), wobei die Trägerplatte (2) parallel zu der Grundebene (21) angeordnet ist und die Leuchtdioden (3) einen Grundkörper (4) aufweisen, der in Abstrahlrichtung (6) geneigt schräg auf der Trägerplatte (2) angeordnet ist, dass der Grundkörper (4) an seinem der Trägerplatte (2) in einem Abstand (18) benachbarten ersten Ende (9) ein erstes Paar von Kontaktbeinchen (10) aufweist, deren freie Enden (22) in Führungsbohrungen (13) der Trägerplatte befestigt sind, und dass der Grundkörper (4) an seinem dem ersten Ende (9) gegenüberliegenden zweiten Ende (11) ein zweites Paar von Kontaktbeinchen (12) aufweist, das den Grundkörper (4) gegenüber der Trägerplatte (2) mechanisch hält, **dadurch gekennzeichnet, dass** die Trägerplatte (2) einen Durchbruch (14) aufweist, in den der Grundkörper (4) mit seinem zweiten Ende (11) hineinragt.

2. Leuchtdiodenanordnung nach Anspruch 1, **dadurch gekennzeichnet, dass** das zweite Paar von Kontaktbeinchen (12) mit seinen freien Enden (16) an einer Unterseite (17) der Trägerplatte (2) anliegt.

3. Leuchtdiodenanordnung nach einem Anspruch 1 oder 2, **dadurch gekennzeichnet, dass** eine Mehrzahl von parallel zueinander angeordneten Leuchtdioden (3) in den Durchbruch (14) hineinragt.

4. Leuchtdiodenanordnung nach einem der Ansprüche 1 bis 3, **dadurch gekennzeichnet, dass** die Breite des Durchbruchs (14) den Neigungswinkel (20) der Leuchtdiode (3) bestimmt.

5. Leuchtdiodenanordnung nach einem der Ansprüche 1 bis 4, **dadurch gekennzeichnet, dass** die Leuchtdioden (3) in unterschiedliche Abstrahlrichtungen (6) ausgerichtet sind.

6. Leuchtdiodenanordnung nach einem der Ansprüche 1 bis 5, **dadurch gekennzeichnet, dass** die Trägerplatten (2) auf ihrer den Leuchtdioden (3) abgewandten Unterseite (17) ein Wärmeableitelement aufweisen.

7. Leuchtdiodenanordnung nach Anspruch 1, **dadurch gekennzeichnet, dass** der Grundkörper (4) mit seiner der Trägerplatte (2) zugewandten Unterseite (8) gegen eine den Führungsbohrungen (13) zugewandte hintere Innenkante (15) des Durchbruchs (14) anschlägt.

8. Verfahren zur schrägen Anordnung von einer Mehrzahl von Leuchtdioden auf einer Trägerplatte, **dadurch gekennzeichnet, dass** die Leuchtdioden (3) in einem ersten Arbeitsgang mit ihrem an einem ersten Ende (9) eines Grundkörpers (4) angeordneten ersten Paar von Kontaktbeinchen (10) in Führungsbohrungen (13) der Trägerplatte (2) eingesetzt werden, wobei die freien Enden (16) eines an einem dem ersten Ende (9) abgewandten zweiten Ende (11) angeordneten zweiten Kontaktpaares (12) in einen benachbarten Durchbruch (14) hineinragen, dass die Leuchtdioden (3) in einem zweiten Arbeitsgang mit ihrem ersten Paar von Kontaktbeinchen (10) mit der Trägerplatte (2) verlötet werden, dass die Leuchtdioden (3) in einem dritten Arbeitsgang so abgebogen werden, dass die Grundkörper (4) mit ihrem zweiten Ende (11) in die Durchbrüche (14) hineinragen und mit ihrer der Trägerplatte (2) zugewandten Unterseite (8) an eine Innenkante (15) des Durchbruchs (14) anschlagen, und dass in einem vierten Arbeitsgang die freien Enden (16) des zweiten Paares von Kontaktbeinchen (12) gegen die Unterseite (17) der Trägerplatte (2) gebogen werden.

## Claims

1. Arrangement of light emitting diodes, specifically for a signal lamp for vehicles, whose direction of light emission (6) is at a slant with reference to a base plane (21), consisting of a base plate (2) and several light emitting diodes (3) arranged on the base plate, where the base plate (2) is parallel with the base plane (21) and where the light emitting diodes (3) have a body (4) which slants on the base plate (2) in the direction of light emission (6), where the body (4) has a first pair of contact pins (10) at its first end (9) that neighbors the base plate (2) at a distance (18) such that the free ends (22) of the contact pins (10) reside in guide holes (13) which firmly attach them to the base plate, and where the body (4) has a second pair of contact pins (12) at its second end (11) that is located opposite to its first end (9) such that the second pair of contact pins (12) mechanically holds the body (4) away from the base plate (2), wherein the base plate (2) has an opening (14) that the second end (11) of the body (4) dips into.

2. Arrangement of light emitting diodes as in claim 1, wherein the free ends (16) of the second pair of contact pins (12) rest on the underside (17) of the base plate (2).

3. Arrangement of light emitting diodes as in claims 1 or 2, wherein several parallel light emitting diodes (3) dip into the opening (14).

4. Arrangement of light emitting diodes as in one of claims 1 to 3, wherein the width of the opening (14) determines the inclination angle (20) of the light emitting diode (3).

5. Arrangement of light emitting diodes as in one of claims 1 to 4, wherein the light emitting diodes (3) point into different directions of light emission (6).

6. Arrangement of light emitting diodes as in one of claims 1 to 5, wherein the base plates (2) dissipate heat through an element located on their underside (17) facing away from the light emitting diodes (3).

7. Arrangement of light emitting diodes as in claim 1, wherein the underside (8) of the body (4) that faces towards the base plate (2) touches a rear inner edge (15) facing towards the guide holes (13).

8. Method of arranging several light emitting diodes at a slant on a base plate, wherein a first operation inserts a first pair of contact pins (10) located at a first end (9) of a body (4) of the light emitting diodes (3) in guide holes (13) of the base plate (2) such that the free ends (16) of a second pair of contact pins (12) located at a second end (11) facing away from the first end (9) move into a neighboring opening (14), wherein a second operation solders the first pair of contact pins (10) of the light emitting diodes (3) to the base plate (2), wherein a third operation bends the light emitting diodes (3) such that the second end (11) of their bodies (4) dip into the openings (14) and that their undersides (8) facing towards the base plate (2) touch an inner edge (15) of the opening (14), and wherein a fourth operation bends the free ends (16) of the second pair of contact pins (12) up against the underside (17) of the base plate (2).

## Revendications

1. Ensemble de diodes électroluminescentes, en particulier pour un feu de signalisation de véhicule, avec un sens de rayonnement (6) orienté en biais par rapport à un plan de base (21), comprenant une plaque support (2) et une pluralité de diodes électroluminescentes (3) disposées sur la plaque support, où la plaque support (2) est disposée parallèlement au plan de base (21) et les diodes électroluminescentes (3) présentent un corps de base (4) qui est disposé en biais sur la plaque support (2) dans le sens de rayonnement (6), le corps de base (4) présentant à sa première extrémité (9) adjacente de la plaque support (2) - à une certaine distance (18) - une première paire de petits pieds de contact (10), dont les extrémités libres (22) sont fixées dans des orifices de guidage (13) de la plaque support, et le corps de base (4) présentant à sa deuxième extrémité (11) opposée à la première extrémité (9) une deuxième paire de petits pieds de contact (12) qui assure le maintien mécanique du corps de base (4) par rapport à la plaque support (2), **caractérisé en ce que** la plaque support (2) présente une ouverture (14) dans laquelle s'enfonce le corps de base (4) avec sa deuxième extrémité (11).

2. Ensemble de diodes électroluminescentes selon la revendication 1, **caractérisé en ce que** la deuxième paire de petits pieds de contact (12) s'applique contre une face inférieure (17) de la plaque support (2) avec ses extrémités libres (16).

3. Ensemble de diodes électroluminescentes selon la revendication 1 ou 2, **caractérisé en ce qu'**une pluralité de diodes électroluminescentes (3) disposées parallèlement les unes aux autres s'enfonce dans l'ouverture (14).

4. Ensemble de diodes électroluminescentes selon l'une quelconque des revendications 1 à 3, **caractérisé en ce que** la largeur de l'ouverture (14) détermine l'angle d'inclinaison (20) de la diode électroluminescente (3).

5. Ensemble de diodes électroluminescentes selon l'une quelconque des revendications 1 à 4, **caractérisé en ce que** les diodes électroluminescentes (3) sont orientées dans des sens de rayonnement différents (6).

6. Ensemble de diodes électroluminescentes selon l'une quelconque des revendications 1 à 5, **caractérisé en ce que** les plaques supports (2) présentent sur leur face inférieure (17) opposée aux diodes électroluminescentes (3) un élément de dissipation de chaleur.

7. Ensemble de diodes électroluminescentes selon la revendication 1, **caractérisé en ce que** le corps de base (4) vient buter, avec sa face inférieure (8) tournée vers la plaque support (2), contre une arête intérieure arrière (15) tournée vers les orifices de guidage (13) de l'ouverture (14).

8. Méthode de disposition en biais d'une pluralité de diodes électroluminescentes sur une plaque support, **caractérisée en ce que** les diodes électroluminescentes (3) sont, dans une première étape, insérées dans des orifices de guidage (13) de la plaque support (2) avec leur première paire de petits pieds de contact (10) disposée à une première extrémité (9) d'un corps de base (4), moyennant quoi les extrémités libres (16) d'une deuxième paire de contact (12) disposée à une deuxième extrémité (11) opposée à la première extrémité (9) s'enfoncent dans une ouverture adjacente (14), les diodes électroluminescentes (3) étant dans une deuxième étape brasées avec leur première paire de petits pieds de contact (10) avec la plaque support (2), les diodes électroluminescentes (3) étant pliées de façon telle dans une troisième étape que les corps de base (4) s'enfoncent dans les ouvertures (14) avec leur deuxième extrémité (11) et butent avec leur face inférieure (8) tournée vers la plaque support (2) sur une arête intérieure (15) de l'ouverture (14), et les extrémités libres (16) de la deuxième paire de petits pieds de contact (12) étant dans une quatrième étape pliées contre la face inférieure (17) de la plaque support (2).
